# EUROPEAN PATENT APPLICATION

(11) **EP 1 191 120 A2**
(43) Date of publication of application: **27.03.2002**
(21) Application number: 01119653.2
(22) Date of filing: 21.08.2001
(51) Int. Cl.: C23C 14/06, C23C 14/22, C30B 23/02, C30B 29/40, C23C 14/56

(54) **In situ purification of compound phosphorus source for solid source molecular beam epitaxy**

(30) Priority: 22.09.2000 US 668106
(71) Applicant: TRW Inc., Redondo Beach, California 90278 (US)
(72) Inventor: Chin, Patrick T., Marina del Rey, CA 90292 (US)
(74) Representative: Schmidt, Steffen J., Dipl.-Ing.

(57) **Abstract**

A method for removing oxygen and moisture from a phosphorus beam in an MBE deposition apparatus. Gallium phosphide (12) is placed in a generation chamber (10) along with solid indium (14) and solid aluminum (16). When the gallium phosphide is heated to 1000°C, the indium and aluminum melts and forms an alloy (18) with the liquid gallium which is formed when the phosphorus sublimates. The alloy acts as a getter to remove any oxygen and water which is generated from the gallium phosphide. The reaction occurs between the aluminum in the alloy and the oxygen and water.

## Description

### BACKGROUND OF THE INVENTION

### 1. Field of the Invention

The present invention relates generally to a system for generating high purity phosphorus in an MBE system and, more particularly, to a system for removing oxygen and water from a phosphorus source using a liquid alloy of indium, aluminum and gallium.

### 2. Discussion of the Background

In a molecular beam epitaxy (MBE) system, it is desirable to generate phosphorus for deposition on a substrate. One method of doing this is to heat gallium phosphide (GaP) to about 1000°C so that the phosphorus is sublimated. While this source is safer and easier to handle than other sources, it results in a material which is less pure than that coming from red phosphorus cracker. It is believed that impurities come from the GaP crystal which is contaminated with water and oxygen from the air.

It is also known in the prior art to purify gases used in semiconductor processing using a bubbler filled with InGaAl alloy. This is described in an article entitled "A New Technique for Gettering Oxygen and Moisture from Gases Used in Semiconductor Processing" by J.R. Shealy and J.M. Woodall in Applied Physics Letters, Vol. 41, Issue 1, pages 88-89, July 1, 1982. A liquid alloy is formed by dissolving 10 grams of indium and 1.8 grams of aluminum in 100 grams of gallium at 40°C. The gas to be purified is then bubbled through the alloy to remove the unwanted oxygen and water. These are removed by interaction with the aluminum in the alloy.

### SUMMARY OF THE INVENTION

Accordingly, an object of this invention is to provide a simple system for producing a high purity molecular beam for an MBE system.

A still further object of this invention is to provide a novel and inexpensive system for removing impurities generated during the production of a phosphorus beam with a solid source.

Briefly, these and other objects of the invention are achieved by providing a small amount of indium and aluminum in solid form in a phosphorus generation chamber at room temperature which melts during the production of phosphorus and forms a liquid alloy which acts as a getter.

### BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:
Figure 1 is a schematic diagram showing the generation chamber of the present invention at room temperature;
Figure 2 is a schematic diagram showing the generation chamber of the present invention at sublimation temperature.

### DETAILED DESCRIPTION OF THE PREFERRED EMBODIMENTS

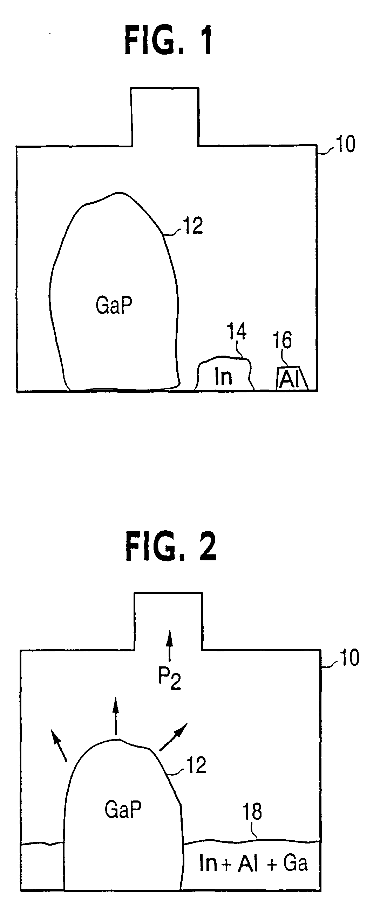

A generation chamber 10 used to generate phosphorus is shown in Figure 1 at room temperature. This chamber is used to generate a molecular beam and is connected to an MBE apparatus. In order to generate the phosphorus, gallium phosphide 12 is first loaded into the chamber preferably in a crucible (not shown). In addition, a smaller amount of indium 14 and aluminum 16 are also loaded into the chamber in solid form. The exact proportions are not critical, although the proportions of the alloy in the article above may be used, for example. No processing is necessary for the materials at this stage. Thus, it is an easy and simple operation to place the three materials into the chamber at the same time.

While the materials are shown as single, solid objects, they each could also be in granular or other form. At room temperature, all three materials remain as solids. As a vacuum is formed in the chamber, the chamber is heated to cause outgassing in a bakeout procedure.

After the vacuum has been obtained and the system is ready for the generation of phosphorus, the generation chamber is heated to a temperature of roughly 1000°C as shown in Fig. 2. Since the melting temperature of indium is roughly 157°C and that of aluminum is roughly 660°C, both of these materials will melt and form a liquid alloy pool in the generation chamber. At the sublimation temperature, the phosphorus sublimates, giving off phosphorus in a gaseous form. The gallium is left in a liquid form and flows into the liquid alloy of indium and aluminum. The three liquids join together to form a liquid alloy of gallium, indium and aluminum 18.

During the sublimation process, impurities such as oxygen and water are given off from the gallium phosphide. These gases react with the aluminum in the liquid alloy and are gettered at that time. In this form, the aluminum reacts very quickly with the gases. The reaction between the oxygen and water impurities and the aluminum in the alloy is the same as in the bubbler device mentioned above. However, it is not possible to bubble the gas through the alloy, since the small pressure of the gases does not permit bubbling. The indium does not react, but is included in the alloy to lower the eutectic temperature. The result is that the phosphorus which exits from the generation chamber is very pure and suitable for using in an MBE application.

By using this method, it is possible to generate a high purity phosphorus flux for MBE growth in a safe manner. By placing the materials in the chamber in their solid form, the alloy can be formed in a very simple fashion without the need for mixing.

Numerous additional modifications and variations of the present invention are possible in light of the above teachings. It is therefore, to be understood that within the scope of the appended claims, the invention may be practiced otherwise than as specifically described herein.

## Claims

1. A method for gettering oxygen and water impurities comprising the steps of:
providing a chamber;
placing gallium phosphide and aluminum within the chamber in solid form;
heating said chamber to cause phosphorus to sublimate from said gallium phosphide;
forming a liquid alloy of gallium and aluminum, wherein said gallium is generated from said gallium phosphide; and
reacting any oxygen and water within the chamber with said liquid alloy to remove said oxygen and water therefrom.

2. The method of claim 1, further comprising the step of:
placing indium within the chamber along with gallium phosphide and aluminum wherein a liquid alloy of gallium, indium and aluminum is formed.

3. The method according to claim 1, wherein said chamber is heated to approximately 1000°C.

4. The method according to claim 1, further comprising the step of generating a phosphorus flux of P2 molecules.

5. An apparatus for gettering oxygen and water impurities comprising:
a vacuum generation chamber;
an amount of gallium phosphide solid material in said chamber; and
an amount of aluminum within said chamber;
wherein heating of the chamber causes phosphorus to sublimate leaving a liquid alloy of gallium and aluminum which reacts with any oxygen and water within said chamber.

6. The apparatus according to claim 5, further comprising:
an amount of indium within said chamber wherein said liquid alloy includes gallium, indium and aluminum.
